# EUROPEAN PATENT APPLICATION

(11) **EP 1 219 971 A2**
(43) Date of publication of application: **03.07.2002**
(21) Application number: 01310475.7
(22) Date of filing: 14.12.2001
(51) Int. Cl.: G01R 33/34

(54) **MR scanner including liquid cooled RF coil and method for cooling an RF coil**

(30) Priority: 19.12.2000 US 740439
(71) Applicant: GE Medical Systems Global Technology Company LLC, Waukesha, Wisconsin 53188-1696 (US)
(72) Inventor: Dean, David E., Hartland, Wisconsin 53029 (US); Hugg, James W., Kiryat Hayim (IL); Assif, Benny, Ramat Hasharon (IL)
(74) Representative: Goode, Ian Roy

(57) **Abstract**

A method and apparatus for cooling MRI system (26) components including components that reside inside an RF shield (140) such as an RF coil (152), a receiver coil, a patient support table (20) and a patient enclosure wall (32) wherein the cooling system employs a liquid coolant essentially devoid of protons and to that end, essentially devoid of hydrogen atoms.

## Description

The field of the invention is nuclear magnetic resonance imaging methods and systems. More particularly, the invention relates to an MRI system that includes a liquid cooling system that is at least partially disposed within a system RF shield.

Any nucleus which possesses a magnetic moment attempts to align itself with the direction of the magnetic field in which it is located. In doing so, however, the nucleus precesses around this direction at a characteristic angular frequency (Larmor frequency) which is dependent on the strength of the magnetic field and on the properties of the specific nuclear species (the magnetogyric constant □ of the nucleus). Nuclei which exhibit this phenomena are referred to herein as "spins".

When a region of interest (i.e., a region of human tissue for which an MRI image is to be generated) is subjected to a uniform magnetic field (polarizing field B₀), the individual magnetic moments of the spins in the region attempt to align with the polarizing field, but precess about the direction of the field in random order at their characteristic Larmor frequencies. A net magnetic moment M_{z} is produced in the direction of the polarizing field, but the randomly oriented magnetic components in the perpendicular, or transverse, plane (x-y plane) cancel one another.

If, however, the region of interest is subjected to a magnetic field (excitation field B₁) that is in the x-y plane and that is near the Larmor frequency, the net aligned moment Mz may be "tipped" into the x-y plane to produce a net transverse magnetic moment Mₜ which is rotating or spinning in the x-y plane at the Larmor frequency.

The practical value of this phenomenon resides in the signal that is emitted by the excited spins after the excitation signal B₁ is terminated. While the signal emitted by a single spin is extremely small and difficult to detect, where a portion of the region of interest includes many emitting nuclei, the strength of the emitted signal is appreciable and can be detected. The emitted NMR signals are digitized and processed to generate an NMR data set.

To generate a useful NMR data set it is of course necessary to determine the point of origin of each NMR signal sensed. To determine the point of origin of an NMR signal, each NMR signal can be encoded with spatial information. While there are many different schemes for encoding position information in NMR signals, an exemplary position encoding technique is commonly referred to as "spin-warp".

According to the spin-warp scheme, spatial encoding is accomplished by employing three magnetic gradient fields (Gₓ, G_{y}, and G_{z}) which have the same direction as polarizing field B₀ and which have gradients along the x, y and z axes, respectively. By controlling the strength of these gradients during each NMR cycle, the spatial distribution of spin excitation can be controlled and the point of origin of the resulting NMR signals can be identified.

As indicated above a large number of signal emitting nuclei have to be present in a portion of a region of interest in order to generate combined signals capable of detection. Thus, when imaging a specific region it is important that the nuclei selected for excitation and signal emission be plentiful within the region. In the case of human tissue, it is known that the hydrogen atom is plentiful and that the primary isotope of hydrogen is the proton. For this reason and because the proton is characterized by a favorable magnetic moment, the proton is typically the nucleus of choice for magnetic resonance imaging (MRI) of human tissue.

Thus, a typical MRI system includes an excitation coil, an RF coil and a plurality of gradient coils that together control the magnetic fields required to generate MR signals needed for imaging purposes. Each of the gradient coils generally includes a multiplicity of turns of conductive wire, with total lengths of up to several hundred meters.

It is well known in the NMR field that RF fields lose a significant portion of their energy if the RF fields impinge upon the conductive wires of the gradient coils. While the reason for RF field energy loss is not fully understood, the RF field loss is probably associated with high current resonances exciting the gradient structure and producing associated high losses. Any RF power loss, in the gradient coils or otherwise, lowers the quality factor Q of the RF coil and consequently lowers the signal-to-noise ratio (SNR) attainable by an MRI system.

Accordingly, it is highly desirable to prevent penetration of the RF field into the surrounding gradient coils. To separate the gradient and RF coils, most MRI systems position the RF coil inside the gradient coils and include a shield positioned between the RF coil and the gradient coils. An RF space is thus formed within RF shield and the RF coil is disposed within the RF space.

There are several characteristics that are often considered when determining the relative value of a specific MRI system configuration. Some important value indicating characteristics include system reliability, resulting image resolution, efficiency and size. Reliability, efficiency and resulting image resolution should be high, and overall system size should be minimized in an ideal MRI system. Unfortunately, with each of these factors there are several practical constraints that limit system configurations in ways that effectively restrict improvements. One important constraint that adversely affects each of these factors is system heat.

As well known in the MRI industry, high power MRI systems consume large amounts of electrical power. In particular, the gradient and RF coils consume excessive amounts of power and thus these coils generate significant heat. As one would expect, excessive heat can cause system components to deteriorate or fail prematurely and hence adversely affects reliability. In addition, heat can be an annoyance to a patient during the imaging process and, if excessive, could injure a patient. For this reason there are regulations that stipulate the maximum temperature of a patient support table that effectively limit the amount of power that can be used in any MRI system.

One way to minimize heat is to reduce coil currents but that solution reduces performance and can also adversely effect overall system efficiency.

Some systems have been designed that provide cooling air spaces between coils and that pass cooling air through the spaces to dissipate coil heat. Unfortunately, designs of this type increase overall system volume and size. In addition, while air clearly reduces coil temperatures, in some cases the degree of cooling is insufficient to drive the coils at maximum coil currents and thus performance in these systems is minimized.

One other solution has been to provide a hermetically sealed liquid cooling system with cooling conduits adjacent the gradient coils. According to solutions of this ilk, during field generation and data acquisition liquid coolant (e.g., water) is pumped through the system to cool the coils.

Unfortunately, while liquid cooling systems have worked well for the purpose of cooling gradient coils, such systems have not been applied to cooling system components that reside inside the RF space such as the RF coils, the patient support table, etc. The primary reason for not providing a liquid cooled configuration that extends into the RF space is that coolant hydrogen atoms, like human tissue, include a large number of protons that, when inside the RF shield, tend to generate NMR signals. These spurious signals, like the signals generated by the excited human tissue, are detected by the detector coils and distort the resulting data and associated images. Thus, liquid cooling systems have been limited to areas outside the RF shield to avoid spurious signal excitation and air cooling systems have been employed for cooling the RF coils.

Because air spaces for pumping the cooling air are required in air cooled systems, overall system volume cannot be reduced to eliminate the spaces. In addition, as indicated above, liquid cooling does a better job cooling system components and therefore higher currents and cooling efficiency must be sacrificed in air-cooled systems. Moreover, because higher coil currents cause stronger signal generation, resulting image resolution is reduced when temperatures cause a reduction in coil currents. Specifically, because the maximum patient support table temperature is regulated and specified, RF coil current has to be limited appreciably and thus performance is minimized.

An exemplary embodiment of the invention includes an apparatus for reducing MRI system operating temperature where the MRI system includes an RF coil, a set of gradient coils and an RF shield, the RF shield formed about an RF space, the RF coil positioned within the RF space and formed about an imaging area and the gradient coils formed about the RF shield such that the shield de-couples the RF coil from the gradient coils. The apparatus comprises a liquid cooling source positioned outside the RF space; a pump linked to the source for pumping coolant therefrom; and at least one conduit linked to the pump to receive liquid pumped thereby and including at least a conduit portion that extends into the RF space such that at least a portion of the heat generated within or migrated into the RF space is absorbed by the conduit portion and the liquid flowing therein.

In one embodiment the liquid may be essentially devoid of protons. To this end the liquid may be essentially devoid of hydrogen atoms and in fact may be devoid of hydrogen atoms.

The system may further include at least one of a patient support table, a patient enclosure wall and a receiver coil within the RF space and the conduit portion that extends into the RF space may be proximate at least one of the RF coil, patient support table, patient enclosure wall and receiver coil so that heat generated by the at least one of the coils, table and wall or that migrates into the space is absorbed by the conduit.

In one aspect the conduit may include at least a portion that is in direct contact with the RF coil. In another aspect the conduit may include a conduit configuration including many conduits that are positioned throughout the RF coil to absorb heat from various parts of the coil. Still in another aspect the conduits may be embedded within the RF coil. In the alternative the conduit may be embedded at least in part in either the table or the patient enclosure wall or may be at least in contact with one or both.

In one embodiment the source includes a heat rejecter and the conduit forms a closed circuit that passes from the pump back to the heat rejecter.

In some embodiments the MRI system also includes heat generating components outside the RF space and the conduit also includes a second conduit portion that extends outside the RF space and proximate the heat generating components outside the RF space so as to absorb heat from the heat generating components.

The invention also includes a method for reducing MRI system operating temperature where the MRI system includes an RF coil, a set of gradient coils and an RF shield, the RF shield formed about an RF space, the RF coil positioned within the RF space and formed about an imaging area and the gradient coils formed about the RF shield such that the shield de-couples the RF coil from the gradient coils. The method comprises the steps of: providing a liquid cooling source positioned outside the RF space; providing a conduit including at least a portion that extends into the RF space such that at least a portion of the heat generated within the RF space is absorbed by the conduit portion and the liquid flowing therein; and pumping coolant from the source through the conduit.

The liquid may be essentially devoid of protons. The liquid may also be essentially devoid or totally devoid of hydrogen atoms.

The system may also include at least one of a patient support table, a receiver coil and a patient enclosure wall and the step of providing the conduit may include providing the conduit such that the conduit portion that extends into the RF space is proximate at least a portion of the RF coil so that heat generated by the coil or migrated into the coil is absorbed by the conduit. According to the method the step of providing the conduit may include providing at least a portion that is in direct contact with the RF coil. Moreover the step of providing the conduit may include the step of providing a conduit configuration including many conduits that are positioned throughout the RF coil to absorb heat from various parts of the coil. In the alternative the method may include providing the conduit includes providing at least a part of the conduit embedded within one of the RF coil, the support, the enclosure and the receiver coil.

These and other embodiments and aspects of the invention will become apparent from the following description. In the description, reference is made to the accompanying drawings, in which:
Fig. 1 is a block diagram of an MRI system which employs the present invention;
Fig. 2 is a schematic diagram of a liquid coolant configuration according to the present invention;
Fig. 3 is similar to Fig. 2, albeit illustrating another liquid coolant configuration according to the present invention;
Fig. 4 is similar to Fig. 2, albeit illustrating yet another liquid coolant configuration according to the present invention;
Fig. 5 is a flow chart illustrating a method according to the present invention;
Fig. 6 is a schematic illustrating relative positions of a cooling conduit and a heat generating component;
Fig. 7 is a schematic similar to fig. 6, albeit of another embodiment; and
Fig. 8 is similar to Fig. 6, albeit of yet another embodiment.

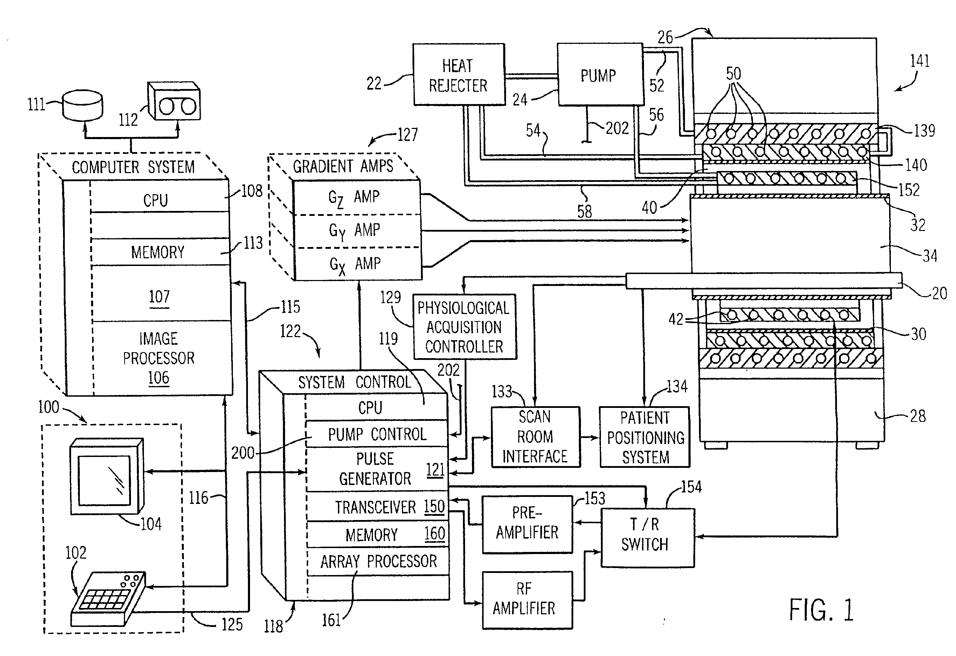

Referring first to Fig. 1, there is shown the major components of a preferred MRI system which incorporates the present invention. To this end the components illustrated include an operators console 100, a computer system 107, a system control 122, a set of gradient amplifiers 127, a physiological acquisition controller 129, a scan room interface 133, a positioning system 134, amplifiers 153 and 151, a switch 154, a patient support table 20, a heat rejecter 22, a fluid pump 24 and field generating and data collecting system collectively referred to by numeral 26.

System 26 includes a gradient coil set collectively referred to by numerals 139 and 140, a polarizing magnet (not illustrated but within housing 28), an RF coil 152, a housing 28, an RF shield 30 and a patient enclosure wall 32. Wall 32 forms an annular receiving or imaging area 34 for receiving table 20 and a patient supported thereon.

RF coil 152 is formed about wall 32 and is surrounded by RF shield 30. Shield 30 is in turn surrounded by polarizing magnet and gradient coils 139 and 140. Shield 30 is provided to de-couple the RF and gradient coils and various constructions of the shield are well know in the MRI art. Thus, shield 30 forms an "RF space" 40 in which the RF coil and the enclosure wall 32 reside.

As illustrated a series of hermetically sealed conduits or tubes collectively referred to by numeral 50 are interspersed within each of the gradient coils 139 and 140. Each tube is linked to pump 24 and heat rejecter 22 via inlet and outlet conduits 52, 54, respectively, to form a closed circuit from rejecter 22 through pump 24 to the coils and back again to the rejecter 22. In this manner cooling liquid can be provided to the field generating system components that reside outside the RF space 40.

Importantly, for the purposes of the present invention, it has been recognized that, while using a hydrogen based liquid coolant to cool system components within the RF space can lead to spurious NMR signals, if a coolant that is essentially devoid of protons is employed, essentially all spurious signals can be eliminated. As indicated above, the Larmor frequency selected for imaging human tissue causes protons, the primary isotope of hydrogen, to generate NMR signals. Thus, a coolant that does not include protons will not generate NMR signals that are detected by the MRI system. To this end, it has been recognized that by employing a non-hydrogen based coolant the spurious signals can essentially be eliminated from the data collected during a NMR imaging session.

An exemplary non-hydrogen based coolant that can be used within the RF space without causing spurious signals is sold by 3M under the trademark FLUORINERT that is advertised as a liquid for use in electronics reliability testing. Specifically, any of the Fluorinert family members including FC-40, FC-43, FC-72, FC-77 or FC-84 will work with the present invention. It should be recognized that while a small set of non-hydrogen based coolants are identified herein it is contemplated that many other non-hydrogen based coolants could be used with the inventive system. The best non-hydrogen based coolant to use would depend on the thermal properties (i.e., ability to absorb and transfer heat) of the coolant.

Thus, as illustrated in Fig. 1, the invention also includes a series of hermetically sealed conduits or tubes collectively referred to by numeral 42 positioned within the RF space 40 to cool system components therein. The system in Fig. 1 includes liquid cooling for the RF coil 152 inside the RF space and does not illustrate cooling of other components inside the RF space. Subsequent figures illustrate additional embodiments where coolant is used to cool other components in the RF space including the patient enclosure wall 32 and the patient support table 20. Each tube 42 is linked to pump 24 and heat rejecter 22 via inlet and outlet conduits 56 and 58, respectively, to form a closed circuit from rejecter 22 through pump 24 to the coils and back again to the rejecter 22. In this manner cooling liquid can be provided to any of the components that reside inside the RF space 40.

The advantages of a system that can employ a liquid coolant are many and include, among others, enhanced patient comfort, increased RF currents, increased system performance in terms of resolution, a reduced size as air ducts required by prior air cooled systems can be eliminated, and greater overall system efficiency.

Referring still to Fig. 1, operation of the system illustrated is controlled from operator console 100 that includes a keyboard and control panel 102 and a display 104. The console 100 communicates through a link 116 with separate computer system 107 that enables an operator to control the production and display of images on the screen 104. The computer system 107 includes a number of modules that communicate with each other through a backplane. These include an image processor module 106, a CPU module 108 and a memory module 113, known in the art as a frame buffer for storing image data arrays.

The computer system 107 is linked to a disk storage 111 and a tape drive 112 for storage of image data and programs, and it communicates with separate system control 122 through a high speed serial link 115.

The system control 122 includes a set of modules connected together by a backplane. These include a CPU module 119 and a pulse generator module 121 that connects to the operator console 100 through a serial link 125. It is through this link 125 that the system control 122 receives commands from the operator that indicate the scan sequence to be performed.

The pulse generator module 121 includes field specifying circuitry that comprises both RF electronics and gradient controlling electronics required to operate the system components to carry out the desired scan sequence. To this end module 121 produces data that indicates the timing, strength and shape of the RF pulses which are to be produced, and the timing of and length of the data acquisition window. The pulse generator module 121 also connects to the set of gradient amplifiers 127, to indicate the timing and shape of the gradient pulses to be produced during the scan.

The pulse generator module 121 also receives patient data from the physiological acquisition controller 129 that receives signals from a number of different sensors connected to the patient, such as ECG signals from electrodes or respiratory signals from a bellows. And finally, the pulse generator module 121 connects to the scan room interface circuit 133 that receives signals from various sensors associated with the condition of the patient and the magnet system. It is also through the scan room interface circuit 133 that the patient positioning system 134 receives commands to move the patient support table 20 to the desired position for a scan.

The gradient waveforms produced by the pulse generator module 121 are applied to the gradient amplifier set 127 comprised of G[x], G[y ]and G[z] amplifiers. Each gradient amplifier excites a corresponding gradient coil in an assembly generally designated 139 and 140 to produce the magnetic field gradients used for position encoding acquired signals. The gradient coil assembly 139 forms part of a magnet assembly 141 which includes a polarizing magnet (not illustrated) and an RF coil 152.

A transceiver module 150 in the system control 122 produces pulses that are amplified by an RF amplifier 151 that is coupled to the RF coil 152. The resulting signals radiated by the excited nuclei in the patient may be sensed by the same RF coil 152 and coupled through the transmit/receive switch 154 to a preamplifier 153. The amplified NMR signals are demodulated, filtered, and digitized in the receiver section of the transceiver 150.

The transmit/receive switch 154 is controlled by a signal from the pulse generator module 121 to electrically connect the RF amplifier 151 to the coil 152 during the transmit mode and to connect the preamplifier 153 during the receive mode. The transmit/receive switch 154 also enables a separate local RF coil (for example, a head coil or surface coil) to be used in either the transmit or receive mode. The NMR signals picked up by the RF coil 152 are digitized by the transceiver module 150 and transferred to a memory module 160 in the system control 122.

When a scan is completed and an entire array of data has been acquired in the memory module 160, an array processor 161 operates to Fourier transform the data into an array of image data. This image data is conveyed through the serial link 115 to the computer system 107 where it is stored in the disk memory 111. In response to commands received from the operator console 100, this image data may be archived on the tape drive 112, or it may be further processed by the image processor 106 and conveyed to the operator console 100 and presented on the display 104.

Referring still to Fig. 1, control 121 also includes a pump control that is linked via a line 202 to pump 24. Control 200 turns on pump 24 during imaging sessions and may continue to drive pump 24 for a time after each imaging session to cool system components. In addition, although not illustrated, control 200 may be equipped to receive feedback information from system 26 that can be used to fine tune the temperature of system 26 components and the ambient within imaging area 34. Systems for controlling temperature based on feedback current are well known in the controls art generally.

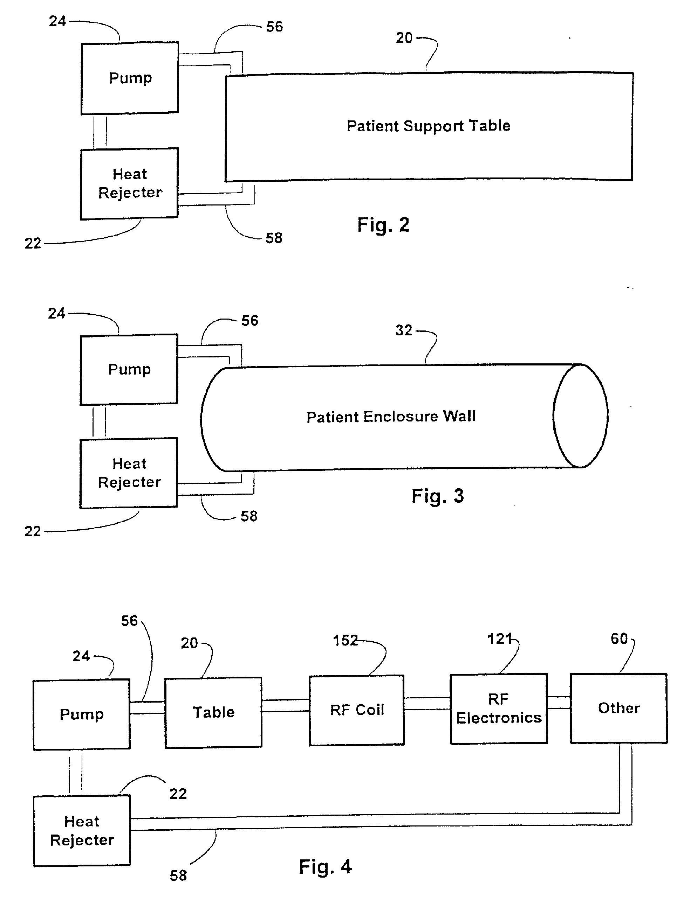

Referring now to Fig. 2, instead of cooling the RF coil 152 as illustrated in Fig. 1, the heat rejecter 22 and pump 24 may be linked to the patient support table 20 to cool the table 20 and maintain the table temperature below the temperature required by regulation. To this end, as indicated above, there are regulations that stipulate the maximum table temperature allowed in an MRI system. In typical systems, the table 20 heats up due to heat generated by the RF coils 152 and therefore, the current through coils 152 has to be minimized so that table 20 does not heat up. With the embodiment of Fig. 2, the temperature of table 20 can be easily controlled to be below the regulated temperature and therefore coil current can be increased appreciably.

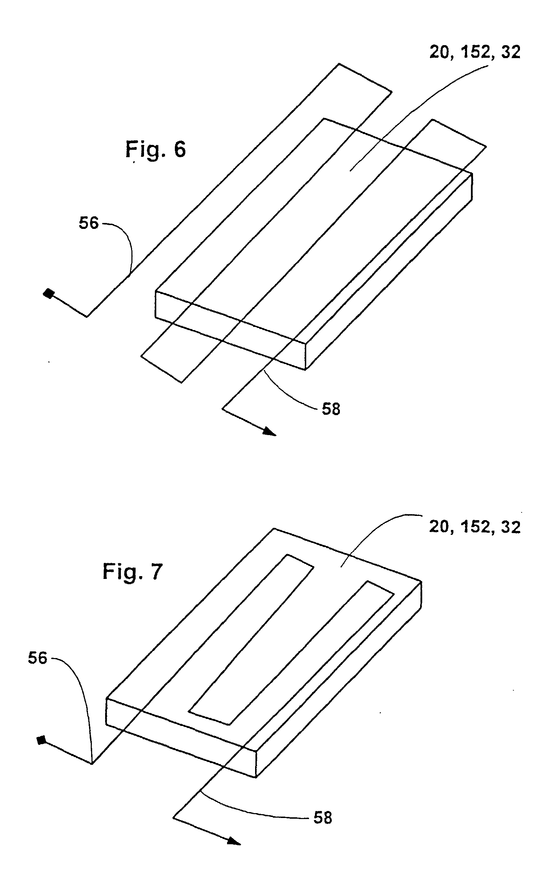

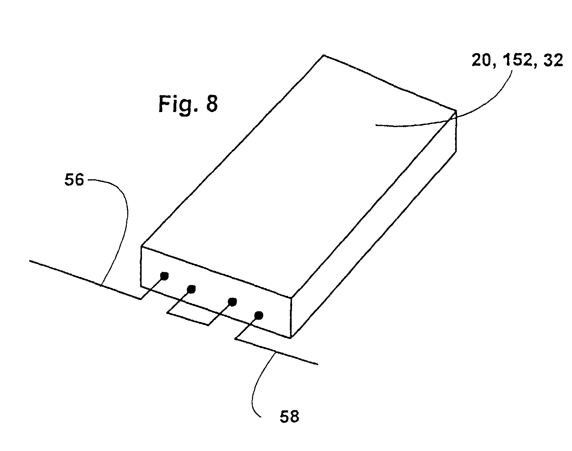

Referring now to Fig. 3, instead of cooling either the RF coils 152 or table 20 as illustrated in Figs. 1 and 2, respectively, rejecter 22 and pump 24 may be linked directly to the patient enclosure wall 32 for cooling wall 32 and maintaining a comfortable ambient temperature within imaging space 34. The cooling tube may either be in contact with wall 32 or may be embedded within the wall and the pattern of cooling tubes associated with wall 32 may take may different forms (i.e., linear along the length of wall 32, spirally around the wall 32, having tubes on the inside or the outside of wall 32, etc.). To this end, referring to Figs. 6-8, a block representing a heat generating system component that may reside inside RF space 40 is illustrated and identified by numerals 20 (i.e., the table) 152 (i.e., the RF coil) and 32 (i.e., the wall). In Fig. 6 the table 56-58 is proximate the block, in Fig. 7 tube 56, 58 is in contact with the block and in Fig. 8 the tube 56-58 is partially embedded within the block.

Referring now to Fig. 4, while rejecter 22 and pump 24 may be linked separately to each component within the RF space 40, it is also contemplated that components to be cooled within space 40 could be linked in series. In addition, it is contemplated that components within RF space 40 and that reside outside space 40 that have to be cooled could be linked in series with a second portion of the conduit outside the RF space. For example, gradient coils 139 and 140 and RF coils 152 in Fig. 1 could be linked in series with pump 24 and heat rejecter 22. Moreover referring also to Fig. 1, any system components illustrated in Fig. 1 that need to dissipate heat could be linked in series or separately to rejecter 22 and pump 24. For example, RF electronics inside pulse generator module 121 could be linked to rejecter 22 and pump 24 for cooling purposes. Referring again to Fig. 4, an exemplary series linkage of system components is illustrated and includes table 20, RF coil 152, RF electronics (e.g., 121), a block 60 indicating any other components that need to dissipate heat and heat rejecter 22.

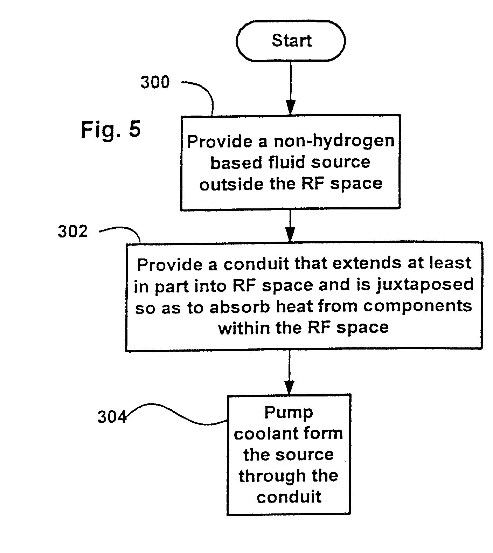

Referring now to Fig. 5, an exemplary method according to the present invention is illustrated. To this end, beginning at block 300, a non-hydrogen based fluid source is provided outside the RF space. Continuing, at block 302, a conduit is provided that extends at least in part into the RF space and is juxtaposed so as to absorb heat from components within the RF space. To this end, the conduit portion that extends into the RF space may be juxtaposed adjacent the RF coil or may be embedded within the RF coil or may be in contact with the RF coil. Similarly, the conduit portion within the RF space may be positioned adjacent the patient support bed, may extend within the support bed or may contact the outside surface of the support bed.

Continuing, at block 304, coolant is pumped through the conduit so as to cool components within the RF space.

It should be understood that the methods and apparatuses described above are only exemplary, and that various modifications could be made by those skilled in the art. For example, the invention can be employed where the RF and receiver coils are separate. In addition, while the embodiment above contemplates a system including a single pump where the same coolant is used inside and outside the RF space, the invention contemplates dual-pump systems where water or some other liquid is used to cool system components outside the RF space and non-hydrogen based coolant is used to cool components inside the space. This embodiment is particularly advantageous as water tends to be a better coolant than the non-hydrogen coolants and is less expensive. Thus, in Fig. 1 pump 24 may in fact include two pumps, one for water and another for the non-hydrogen coolant.

For completeness, various aspects of the invention are set out in the following numbered clauses:
1. An apparatus for reducing MRI system operating temperature where the MRI system (26) includes an RF coil (152), a set of gradient coils (139) and an RF shield (140), the RF shield (140) formed about an RF space (40), the RF coil (152) positioned within the RF space (40) and formed about an imaging area (34) and the gradient coils (139) formed about the RF shield (140) such that the shield (140) de-couples the RF coil (152) from the gradient coils (139), the apparatus comprising:
   a liquid cooling source (22) positioned outside the RF space (40);
   a pump (24) linked to the source (22) for pumping coolant therefrom; and
   at least one conduit (52) linked to the pump (24) to receive liquid pumped thereby and including at least a conduit portion (42) that extends into the RF space (40) such that at least a portion of the heat generated within the RF space (40) is absorbed by the conduit portion (42) and the liquid flowing therein.
2. The apparatus of clause 1 wherein the liquid is essentially devoid of protons.
3. The apparatus of clause 2 wherein the liquid is essentially devoid of hydrogen atoms.
4. The apparatus of clause 3 wherein the liquid is devoid of hydrogen atoms.
5. The apparatus of clause 2 wherein the system (26) further includes at least one of a patient support table (20), a patient enclosure wall (32) and a receiver coil within the RF space (40) and wherein the conduit portion (42) that extends into the RF space (40)is proximate at least one of the RF coil, patient support table, patient enclosure wall and receiver coil so that heat generated by or transferred to the at least one of the coils, table and wall is absorbed by the conduit.
6. The apparatus of clause 5 wherein the conduit (56) includes at least a portion (42) that is in direct contact with the RF coil (152).
7. The apparatus of clause 6 wherein the conduit (56) includes a conduit configuration including many conduits that are positioned throughout the RF (152) coil to absorb heat from various parts of the coil.
8. The apparatus of clause 7 wherein the conduits (42) are embedded within the RF coil (152).
9. The apparatus of clause 2 wherein the source (22) includes a heat rejecter and the conduit (54, 56) forms a closed circuit that passes from the pump (24) back to the heat rejecter (22).
10. The apparatus of clause 2 wherein the MRI system (26) also includes heat generating components outside the RF space (40) and the conduit also includes a second conduit portion (50) that extends outside the RF space (40) and proximate the heat generating components outside the RF space (40) so as to absorb heat from the heat generating components.
11. The apparatus of clause 2 where at least a portion of the conduit is embedded within the table (20).
12. A method for reducing MRI system operating temperature where the MRI system includes an RF coil (152), a set of gradient coils (139) and an RF shield (140), the RF shield (140) formed about an RF space (40), the RF coil (139) positioned within the RF space (40) and formed about an imaging area (34) and the gradient coils (152) formed about the RF shield such that the shield de-couples the RF coil (152) from the gradient coils, the method comprising the steps of:
   providing (300) a liquid cooling source (22);
   providing (302) a conduit (52, 54, 56, 58) including at least a portion (42) that extends into the RF space (40) such that at least a portion of the heat generated within the RF space (40) is absorbed by the conduit portion (42) and the liquid flowing therein; and
   pumping (304) coolant from the source through the conduit.
13. The method of clause 12 wherein the liquid is essentially devoid of protons.
14. The method of clause 13 wherein the liquid is essentially devoid of hydrogen atoms.
15. The method of clause 14 wherein the liquid is devoid of hydrogen atoms.
16. The method of clause 13 wherein the system also includes at least one of a patient support table (20), a receiver coil and a patient enclosure wall (32) and the step of providing the conduit includes providing the conduit such that the conduit portion that extends into the RF space (40) is proximate at least a portion of the RF coil (152) so that heat generated by the coil is absorbed by the conduit (50).
17. The method of clause 16 wherein the step of providing the conduit includes providing at least a portion (42) that is in direct contact with the RF coil (152).
18. The method of clause 17 wherein the step of providing the conduit includes the step of providing a conduit configuration including many conduits (42) that are positioned throughout the RF coil (152) to absorb heat from various parts of the coil.
19. The method of clause 16 wherein the step of providing the conduit includes providing at least a part (42) of the conduit embedded within one of the RF coil (152), the support (20), the enclosure (32) and the receiver coil.
20. An apparatus for reducing MRI system operating temperature where the MRI system includes an RF coil (152), a set of gradient coils (139) and an RF shield (140), the RF shield (140) formed about an RF space (40), the RF coil (152) positioned within the RF space (40) and formed about an imaging area (34) and the gradient coils (139) formed about the RF shield (140) such that the shield de-couples the RF coil (152) from the gradient coils (139), the apparatus also including at least one of a patient support table (20), a receiver coil and a patient enclosure wall (32) inside the RF space (40), the apparatus comprising:
   a heat rejecter (22) positioned outside the RF space;
   a pump (24) linked to the source for pumping a coolant therefrom where the coolant is essentially devoid of hydrogen atoms ; and
   at least one conduit (52, 54, 56, 68) linked to the pump to receive liquid pumped thereby and including at least a conduit portion (50) that extends into the RF space (40) and adjacent at least one of the RF coil (152), the table (20), the wall (32) and the receiver coil such that at least a portion of the heat generated within the RF space (40) by the at least one of the coils, table and wall is absorbed by the conduit portion and the liquid flowing therein.
21. A method for reducing MRI system operating temperature where the MRI system includes an RF coil (152), a set of gradient coils (139) and an RF shield (140), the RF shield (140) formed about an RF space (48), the RF coil positioned within the RF space (40) and formed about an imaging area (34) and the gradient coils (152) formed about the RF shield (140) such that the shield (140) de-couples the RF coil (152) from the gradient coils (139), the apparatus also including at least one of a patient support table (20), a receiver coil and a patient enclosure wall (33) inside the RF space (40), the method comprising the steps of:
   providing (300) at least one conduit including at least a conduit portion (50) that extends into the RF space (40) and adjacent at least one of the RF coil (152), the table (20), the wall (32) and the receiver coil; and
   pumping (304) a liquid coolant through the conduit during an MRI scan to absorb heat from the at least one of the coils (152), the wall (32) and the table (20) wherein the liquid coolant is essentially devoid of hydrogen atoms.

## Claims

1. An apparatus for reducing MRI system operating temperature where the MRI system (26) includes an RF coil (152), a set of gradient coils (139) and an RF shield (140), the RF shield (140) formed about an RF space (40), the RF coil (152) positioned within the RF space (40) and formed about an imaging area (34) and the gradient coils (139) formed about the RF shield (140) such that the shield (140) de-couples the RF coil (152) from the gradient coils (139), the apparatus comprising:
a liquid cooling source (22) positioned outside the RF space (40);
a pump (24) linked to the source (22) for pumping coolant therefrom; and
at least one conduit (52) linked to the pump (24) to receive liquid pumped thereby and including at least a conduit portion (42) that extends into the RF space (40) such that at least a portion of the heat generated within the RF space (40) is absorbed by the conduit portion (42) and the liquid flowing therein.

2. The apparatus of claim 1 wherein the liquid is essentially devoid of protons.

3. The apparatus of claim 2 wherein the liquid is devoid, or essentially devoid, of hydrogen atoms.

4. The apparatus of claim 2 wherein the system (26) further includes at least one of a patient support table (20), a patient enclosure wall (32) and a receiver coil within the RF space (40) and wherein the conduit portion (42) that extends into the RF space (40)is proximate at least one of the RF coil, patient support table, patient enclosure wall and receiver coil so that heat generated by or transferred to the at least one of the coils, table and wall is absorbed by the conduit.

5. The apparatus of claim 2 wherein the source (22) includes a heat rejecter and the conduit (54, 56) forms a closed circuit that passes from the pump (24) back to the heat rejecter (22).

6. The apparatus of claim 2 wherein the MRI system (26) also includes heat generating components outside the RF space (40) and the conduit also includes a second conduit portion (50) that extends outside the RF space (40) and proximate the heat generating components outside the RF space (40) so as to absorb heat from the heat generating components.

7. A method for reducing MRI system operating temperature where the MRI system includes an RF coil (152), a set of gradient coils (139) and an RF shield (140), the RF shield (140) formed about an RF space (40), the RF coil (139) positioned within the RF space (40) and formed about an imaging area (34) and the gradient coils (152) formed about the RF shield such that the shield de-couples the RF coil (152) from the gradient coils, the method comprising the steps of:
providing (300) a liquid cooling source (22);
providing (302) a conduit (52, 54, 56, 58) including at least a portion (42) that extends into the RF space (40) such that at least a portion of the heat generated within the RF space (40) is absorbed by the conduit portion (42) and the liquid flowing therein; and
pumping (304) coolant from the source through the conduit.

8. The method of claim 12 wherein the liquid is essentially devoid of protons.

9. An apparatus for reducing MRI system operating temperature where the MRI system includes an RF coil (152), a set of gradient coils (139) and an RF shield (140), the RF shield (140) formed about an RF space (40), the RF coil (152) positioned within the RF space (40) and formed about an imaging area (34) and the gradient coils (139) formed about the RF shield (140) such that the shield de-couples the RF coil (152) from the gradient coils (139), the apparatus also including at least one of a patient support table (20), a receiver coil and a patient enclosure wall (32) inside the RF space (40), the apparatus comprising:
a heat rejecter (22) positioned outside the RF space;
a pump (24) linked to the source for pumping a coolant therefrom where the coolant is essentially devoid of hydrogen atoms ; and
at least one conduit (52, 54, 56, 68) linked to the pump to receive liquid pumped thereby and including at least a conduit portion (50) that extends into the RF space (40) and adjacent at least one of the RF coil (152), the table (20), the wall (32) and the receiver coil such that at least a portion of the heat generated within the RF space (40) by the at least one of the coils, table and wall is absorbed by the conduit portion and the liquid flowing therein.

10. A method for reducing MRI system operating temperature where the MRI system includes an RF coil (152), a set of gradient coils (139) and an RF shield (140), the RF shield (140) formed about an RF space (48), the RF coil positioned within the RF space (40) and formed about an imaging area (34) and the gradient coils (152) formed about the RF shield (140) such that the shield (140) de-couples the RF coil (152) from the gradient coils (139), the apparatus also including at least one of a patient support table (20), a receiver coil and a patient enclosure wall (33) inside the RF space (40), the method comprising the steps of:
providing (300) at least one conduit including at least a conduit portion (50) that extends into the RF space (40) and adjacent at least one of the RF coil (152), the table (20), the wall (32) and the receiver coil; and
pumping (304) a liquid coolant through the conduit during an MRI scan to absorb heat from the at least one of the coils (152), the wall (32) and the table (20) wherein the liquid coolant is essentially devoid of hydrogen atoms.
